# EUROPÄISCHE PATENTSCHRIFT

(11) **EP 0 732 625 B1**
(45) Veröffentlichungstag und Bekanntmachung des Hinweises auf die Patenterteilung: **12.09.2001**
(21) Anmeldenummer: 96810123.8
(22) Anmeldetag: 05.03.1996
(51) Int. Cl.: G03F 7/004, G03C 9/08

(54) **Stabilisierung flüssiger strahlungshärtbarer Zusammensetzungen gegen unerwünschte vorzeitige Polymerisation**
Stabilization of liquid radiation-curable compositions against premature polymerization
Stabilisation de compositions liquides et durcissables par rayonnement contre la polymérisation prématurée

(30) Priorität: 13.03.1995 CH 71795
(43) Veröffentlichungstag der Anmeldung: 18.09.1996
(73) Patentinhaber: Vantico AG, 4057 Basel (CH)
(72) Erfinder: Schulthess,Adrian, Dr., 1734 Tentlingen (CH); Steinmann, Bettina, Dr., 1724 Praroman (CH); Hofmann, Manfred, Dr., 1723 Marly (CH)

(56) Entgegenhaltungen:
- WO-A-93/18437
- US-A- 4 575 330
- US-A- 5 350 715
- US-A- 5 378 802
- DATABASE WPI Week 9501 Derwent Publications Ltd., London, GB; AN 95-001969 XP002008523 & JP-A-06 289 612 (NIPPON ZEON KK) , 18.Oktober 1994
- DATABASE WPI Week 8943 Derwent Publications Ltd., London, GB; AN 89-312247 XP002008524 & JP-A-01 228 560 (HITACHI CHEMICAL KK) , 12.September 1989

## Beschreibung

Die vorliegende Erfindung betrifft ein Verfahren zur stereolithographischen Herstellung dreidimensionaler Körper mit Hilfe einer flüssigen strahlungshärtbaren Zusammensetzung, enthaltend eine kationisch polymerisierbaren Verbindung und einen Photoinitiators für die kationische Polymerisation.

Flüssige strahlungshärtbare Zusammensetzungen, enthaltend eine kationisch polymerisierbare Verbindung und einen Photoinitiator für die kationische Polymerisation, sind in der Technik weitverbreitet und finden z. B. als strahlungshärtbare Lacke, Photoresists oder zur stereolithographischen Herstellung dreidimensionaler Gegenstände Verwendung. Den Photoinitiator für die kationische Polymerisation bildet bei diesen Zusammensetzungen eine latent stark saure Verbindung, d. h. eine Verbindung, die bei Bestrahlung eine Photoreaktion unter Bildung einer starken Säure eingeht, die dann die kationische Polymerisation einleitet.

Bei der praktischen Anwendung der genannten strahlungshärtbaren Zusammensetzungen treten jedoch öfters Komplikationen auf, weil die kationische Polymerisation vorzeitig, d.h. schon vor der Bestrahlung, einsetzt. Der Grund hierfür ist im allgemeinen das vorzeitige Auftreten von Säuren in den Zusammensetzungen. Das unerwünschte Auftreten von Säure kann beispielsweise durch eine Zersetzung des Photoinitiators, z. B. durch Feuchtigkeit, Wärme, unbeabsichtigten Lichteinfall oder Streulicht, oder auch durch ein unbeabsichtigtes Einschleppen von Säure zustande kommen und führt oftmals zu einer so starken Zunahme der Viskosität der Zusammensetzungen, dass diese unbrauchbar werden.

Ein derartiges Stabilitätsproblem tritt besonders bei der herkömmlichen stereolithographischen Herstellung dreidimensionaler Körper mit Hilfe von Zusammensetzungen auf Basis einer kationisch polymerisierbaren Verbindung und eines Photoinitiators für die kationische Polymerisation auf. Bei einem stereolithographischen Verfahren werden, wie z. B. im US-Patent US-A-4,575,330 genauer beschrieben ist, die drei dimensionalen Gegenstände aus der flüssigen strahlungshärtbaren Zusammensetzung schichtweise aufgebaut, indem man zunächst eine Schicht der Zusammensetzung bildhaft, d. h. entweder ganzflächig oder in einem vorbestimmten Muster (unter linien- oder vektorförmiger Rasterung), mit einer UV/VIS-Lichtquelle bestrahlt, bis sich in den bestrahlten Bereichen eine Schicht in einer gewünschten Schichtdicke verfestigt hat. Danach bildet man eine neue Schicht der flüssigen strahlungshärtbaren Zusammensetzung auf der schon verfestigten Schicht und bestrahlt diese ebenfalls ganzflächig oder in einem vorbestimmten Muster, wobei sich eine zweite, an der ersten anhaftende verfestigte Schicht bildet. So fährt man immer weiter fort, so dass durch wiederholtes Überschichten des schon verfestigten Materials mit weiterer härtbarer Zusammensetzung und jeweiliges bildmässiges Bestrahlen dieser flüssigen Schicht schliesslich ein zwar noch nicht völlig ausgehärteter, aber schon ausreichend verfestigter Gegenstand der gewünschten Form, auch Grünling genannt, erhalten wird, der aus dem Bad mit der flüssigen Zusammensetzung entfernt werden kann und schliesslich anderweitig durch Wärme und/oder weitere Bestrahlung ausgehärtet wird. Das Stereolithographiebad wird nach Entfernung des Grünlings gegebenenfalls mit frischer härtbarer Zusammensetzung ergänzt und zur erneuten Herstellung eines Grünlings verwendet. Es hat sich nun gezeigt, dass die aus ökonomischen Gründen üblicherweise nur ergänzten kationisch härtbaren Stereolithographiebäder nur eine unbefriedigende Haltbarkeit haben und schon nach relativ kurzer Zeit eine Viskositätszunahme zeigen, die nicht mehr toleriert werden kann, insbesondere weil die Stereolithographie gerade zur Herstellung von Gegenständen mit komplizierten Formen verwendet wird, beispielsweise Formen mit engen Spalten, Ecken oder inneren nur durch ein sehr kleines Loch nach aussen verbundenen Hohlräumen, aus denen hochviskoses Material nicht mehr in ausreichendem Masse abfliessen kann.

In der EP-A-0 126 712 ist bereits beschrieben worden, einer strahlungshärtbaren Zusammensetzung auf Basis einer kationisch polymerisierbaren Verbindung und eines Photoinitiators für die kationische Polymerisation kleine Mengen einer schwachen organischen Base, z. B. eines Nitrils, eines Amids, Lactons oder eines Harnstoffderivats, zur Erhöhung der Lagerstabilität zuzusetzen. Stabilisatoren dieses Typs können jedoch nur in unbefriedigendem Ausmass eingesetzt werden, wenn sie nicht die Photoempfindlichkeit der Zusammensetzungen stark verringern sollen.

Das U.S. Patent (US-A-) 5,350,714 offenbart die Behandlung einer strahlungshärtbaren Zusammensetzungen mit einem lonenaustauscher. Diese Behandlung bezweckt, in der härtbaren Zusammensetzung eventuell vorhandene störende Verunreinigungen vor Gebrauch der Zusammensetzung aus dieser zu entfernen. Die Behandlung erfolgt deshalb nur einmal, unmittelbar vor Benutzung der härtbaren Zusammensetzung. Eine derartige Behandlung kann jedoch nicht die oben geschilderten bei der Stereolithographie auftretenden Probleme mit der während einer längeren Gebrauchszeit der Badzusammensetzung aufgrund einer unerwünschten Polymerisation zunehmenden Viskosität des Bades lösen.

Auch das U.S.-Patent (US-A-) 5,378,802 sowie die DERWENT-Abstracts Nr. 95-001969 und Nr. 89-312247 offenbaren die Entfernung von störenden Metallionen aus Photoresistlösungen und anderen Harzlösungen mit Hilfe von lonenaustauschern.

Gegenstand der vorliegenden Erfindung ist ein Verfahren zur stereolithographischen Herstellung dreidimensionaler Körper mit Hilfe einer flüssigen strahlungshärtbaren Zusammensetzung, enthaltend eine kationisch polymerisierbare Verbindung und einen Photoinitiator für die kationische Polymerisation, bei dem ein basischer lonenaustauscher mit der Zusammensetzung zumindest zeitweise in Kontakt gebracht wird, so dass er die Zusammensetzung gegen einen vorzeitigen Beginn der Polymerisation stabilisiert.

Das erfindungsgemässe Verfahren bindet die unerwünschten Säurepartikel in der flüssigen Zusammensetzung und vermeidet zugleich die Nachteile der Stabilisatoren des Standes der Technik, da es keine niedermolekularen Stabilisatorbasen verwendet, die sich in der strahlungsempfindlichen Zusammensetzung lösen oder sich mit dieser untrennbar vermischen können, sondern unlösliche Stabilisatoren in Form von festen basischen Ionenaustauschermaterialien. Selbst wenn der basische Ionenaustauscher während der Bestrahlung in dem Bereich der strahlungshärtbaren Zusammensetzung verbleibt, der mit der Strahlung in Kontakt kommt, ist eine Verminderung der Photoempfindlichkeit nur auf die unmittelbare Umgebung von Ionenaustauscherpartikeln beschränkt und somit für die Gesamthärtung der Zusammensetzung unbedeutend.

Durch die Verwendung des festen basischen Ionenaustauschers wird jedoch auch die räumliche oder zeitliche Trennung des Kontakts der härtbaren Zusammensetzung mit dem basischen Stabilisator von der Bestrahlung der Zusammensetzung möglich. Bevorzugt wird daher bei dem vorgenannten Verfahren der Ionenaustauscher vor Beginn der Strahlungshärtung zumindest aus dem Teil der strahlungsempfindlichen Zusammensetzung entfernt, der mit der Strahlung in Kontakt kommt, d. h. in den die Strahlung eindringt.

Basische Ionenaustauscher sind dem Fachmann seit langem wohl bekannt und beispielsweise in ULLMANNS ENCYCLOPÄDIE DER TECHNISCHEN CHEMIE, 4. Aufl., Verlag Chemie·Weinheim·New York 1977, Bd. 13, S. 279ff. ausführlich beschrieben. Sie sind auch in vielfacher Form kommerziell erhältlich. Für die vorliegende Erfindung werden organische basische Ionenaustauscher bevorzugt, d. h. Polymere mit basischen Gruppen. Man unterscheidet in der Technik zwischen sogenannten stark basischen und schwach basischen Ionenaustauschern. Bei stark basischen organischen Ionenausstauschern handelt es sich beispielsweise um vernetzte Copolymere von Styrol, Divinylbenzol und [Trimethyl-(styrylmethyl)ammonium]hydroxid oder [Dimethyl-(2-Hydroxyethyl)-styrylmethylammonium]hydroxid.

Für die Zwecke der vorliegenden Erfindung werden besonders schwach basische organische Ionenaustauscher, insbesondere vernetzte Copolymere von Styrol, Divinylbenzol und Dimethylaminomethylstyrol bevorzugt.

Basische Ionenaustauscher, insbesondere die kommerziell verfügbaren Typen, enthalten oftmals noch Wasser und lösliche basische Verunreinigungen. Obwohl es möglich ist, die lonenaustauscher in dieser Form zu verwenden, werden lösliche basische Verunreinigungen bevorzugt aus dem lonenaustauschermaterial entfernt, bevor der Austauscher mit der flüssigen strahlungshärtbaren Zusammensetzung in Kontakt gebracht wird. Beispielsweise wird hierzu das lonenaustauschermaterial, bevorzugt mehrmals, mit polaren organischen Lösungsmitteln, z. B. Ethanol oder Ethylacetat, gewaschen und sorfältig getrocknet, bevor es zum Einsatz kommt und mit der flüssigen strahlungshärtbaren Zusammensetzung in Kontakt gebracht wird. Bei Verwendung von gewaschenen Ionenaustauschern bleibt die Viskosität der härtbaren Zusammensetzung besonders lange niedrig und ihre Photoempfindlichkeit besonders hoch.

Handelsüblich werden lonenaustauscher im allgemeinen in Granulatform geliefert. Es ist jedoch auch denkbar, im erfindungsgemässen Verfahren lonenaustauschermaterial in anderen Anwendungsformen mit hoher spezifischer Oberfläche einzusetzen, z. B. in Form von Filmen oder Stäben oder auch in Form von Röhren oder Schläuchen, durch man die strahlungshärtbare Zusammensetzung beispielsweise auch pumpen könnte.

Die erforderliche Menge lonenaustauscher richtet sich nach der Kapazität des Austauschers und der Intensität und Dauer seines Kontakts mit der strahlungshärtbaren Flüssigkeit. Die Menge kann vom Fachmann mit wenigen einfachen Routineversuchen bestimmt werden. Bevorzugt wird der lonenaustauscher in einer Menge eingesetzt, dass seine gesamte Nutzkapazität 5 bis 80, bevorzugt 5 bis 50 Prozent der Menge Säure äquivalent ist, die aller Initiator für die kationische Polymerisation, der in der strahlungshärtbaren Zusammensetzung vorhanden ist, bilden kann.

Die flüssigen strahlungshärtbaren Zusammensetzungen, die für das erfindungsgemässe Verfahren geeignet sind, können alle üblichen kationisch polymerisierbaren organischen Verbindungen, sowohl allein als auch im Gemisch mit mindestens einer weiteren kationisch oder auch nach einem anderen Mechanismus, z. B. radikalisch, polymerisierbaren Verbindung, enthalten. Hierzu gehören beispielsweise ethylenisch ungesättigte Verbindungen, die nach einem kationischen Mechanismus polymerisierbar sind, wie Mono- und Diolefine, z.B. Isobutylen, Butadien, Isopren, Styrol, a-Methylstyrol, Divinylbenzole, N-Vinylpyrrolidon, N-Vinylcarbazol und Acrolein, oder Vinylether, z.B. Methylvinylether, Isobutylvinylether, Trimethylolpropantrivinylether, Ethylenglykoldivinylether; cyclische Vinylether, z.B. 3,4-Dihydro-2-formyl-2H-pyran (dimeres Acrolein) und der 3,4-Dihydro-2H-pyran-2-carbonsäureester des 2-Hydroxymethyl-3,4-dihydro-2H-pyrans, sowie Vinylester, z.B. Vinylacetat und Vinylstearat. Es kann sich auch um kationisch polymerisierbare heterocyclische Verbindungen handeln, z.B. Ethylenoxyd, Propylenoxyd, Epichlorhydrin, Glycidylether einwertiger Alkohole oder Phenole, z.B. n-Butylglycidylether, n-Octylglycidylether, Phenylglycidylether und Kresylglycidylether; Glycidylacrylat, Glycidylmethacrylat, Styroloxyd und Cyclohexenoxyd; Oxetane, wie 3,3-Dimethyloxetan und 3,3-Di-(chlormethyl)-oxetan; Tetrahydrofuran; Dioxolane, Trioxan und 1,3,6-Trioxacyclooctan; Lactone, wie β-Propiolacton, γ-Valerolacton und ∈-Caprolacton; Spiroethercarbonate Spiroetherester; Thiirane, wie Ethylensulfid und Propylensulfid; Epoxidharze; lineare und verzweigte Polymere mit Glycidylgruppen in den Seitenketten, z.B. Homo- und Copolymere von Polyacrylat- und Polymethacrylat-glycidylestern. Als kationisch polymerisierbare Verbindungen kommen weiterhin Methylolverbindungen in Betracht. Zu den Methylolverbindungen gehören Aminoplaste wie z. B. die N-Hydroxymethyl-, N-Methoxymethyl-, N-n-Butoxymethyl- und N-Acetoxymethylderivate von Amiden oder amidartigen Verbindungen, z. B. cyclischen Harnstoffen wie Ethylenharnstoff (Imidazolidin-2-on), Hydantoin, Uron (Tetrahydro-oxadiazin-4-on), 1,2-Propylenharnstoff (4-Methylimidazolidin-2-on), 1,3-Propylenharnstoff (Hexahydro-2H-pyrimid-2-on), Hydroxypropylenharnstoff (5-Hydroxy-hexahydro-2H-pyrimid-2-on), 1,3,5-Melamin und weitere Polytriazine wie Acetoguanamin, Benzoguanamin und Adipoguanamin. Gewünschtenfalls kann man auch Aminoplaste einsetzen, die sowohl N-Hydroxymethyl- als auch N-Acetoxymethylgruppen enthalten, z. B. Hexamethylolmelamin, in dem 1 bis 3 der Hydroxylgruppen mit Methylgruppen verethert sind. Weitere geeignete Methylolverbindungen sind die Phenoplaste, insbesondere aus einem Phenol und einem Aldehyd hergestellte Resole. Zu den hierfür geeigneten Phenolen gehören Phenol selbst, Resorcin, 2,2-Bis-(p-hydroxyphenyl)-propan, p-Chlorphenol, ein durch eine oder zwei Alkylgruppen mit je 1 bis 9 Kohlenstoffatomen substituiertes Phenol, wie o-, m- und p-Kresol, die Xylenole, p-tert.-Butylphenol und p-Nonylphenol sowie auch phenylsubstituierte Phenole, insbesondere p-Phenylphenol. Der mit dem Phenol kondensierte Aldehyd ist vorzugsweise Formaldehyd, doch kommen auch andere Aldehyde, wie Acetaldehyd und Furfural, in Frage. Gewünschtenfalls kann man ein Gemisch solcher härtbaren Phenol/Aldehydharze verwenden.

Besonders wichtige kationisch polymerisierbare Verbindungen sind Epoxidharze, die im Durchschnitt mehr als eine 1,2-Epoxidgruppe im Molekül besitzen. Solche Harze können eine aliphatische, aromatische, cycloaliphatische, araliphatische oder heterocyclische Struktur haben; sie enthalten Epoxidgruppen als Seitengruppen, oder diese Gruppen bilden einen Teil eines alicyclischen oder heterocyclischen Ringsystems. Epoxyharze dieser Typen sind allgemein bekannt und im Handel erhältlich. Beispielhaft für Epoxyharze dieses Typs sind zu erwähnen:
I) Polyglycidyl- und Poly-(β-methylglycidyl)-ester erhältlich durch Umsetzung einer Verbindung mit mindestens zwei Carboxylgruppen im Molekül und Epichlorhydrin bzw. Glycerindichlorhydrin bzw. β-Methylβ-Methyl-epichlorhydrin. Die Umsetzung erfolgt zweckmässig in Gegenwart von Basen. Als Verbindungen mit mindestens zwei Carboxylgruppen im Molekül können z. B. aliphatische Polycarbonsäuren verwendet werden. Beispiele für diese Polycarbonsäuren sind Glutarsäure, Adipinsäure, Pimelinsäure, Korksäure, Azelainsäure, Sebazinsäure oder dimerisierte bzw. trimerisierte Linolsäure. Es können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure. Weiterhin können aromatische Polycarbonsäuren Verwendung finden, wie beispielsweise Phthalsäure, Isophthalsäure, Trimellitsäure oder Pyromellitsäure. Ebenfalls können auch carboxylterminierte Addukte, z.B. von Trimellitsäure und Polyolen, wie beispielsweise Glycerin oder 2,2-Bis-(4-hydroxycyclohexyl)-propan, verwendet werden.
II) Polyglycidyl- oder Poly-(β-methylglycidyl)-ether erhältlich durch Umsetzung einer Verbindung mit mindestens zwei freien alkoholischen Hydroxygruppen und/oder phenolischen Hydroxygruppen und einem geeignet substituierten Epichlorhydrin unter alkalischen Bedingungen, oder in Anwesenheit eines sauren Katalysators und anschliessender Alkalibehandlung. Ether des genannten Typs leiten sich beispielsweise ab von acyclischen Alkoholen, wie Ethylenglykol, Diethylenglykol und höheren Poly-(oxyethylen)-glykolen, Propan-1,2-diol, oder Poly-(oxypropylen)-glykolen, Propan-1,3-diol, Butan-1,4-diol, Poly-(oxytetramethylen)-glykolen, Pentan-1,5-diol, Hexan-1,6-diol, Hexan-2,4,6-triol, Glycerin, 1,1,1-Trimethylolpropan, Bistrimethylolpropan, Pentaerythrit, Sorbit, sowie von Polyepichlorhydrinen. Die Ether leiten sich aber beispielsweise auch von cycloaliphatischen Alkoholen, wie 1,3- oder 1,4-Dihydroxycyclohexan, Bis-(4-hydroxycyclohexyl)-methan, 2,2-Bis-(4-hydroxycyclohexyl)-propan oder 1,1-Bis-(hydroxymethyl)-cyclohex-3-en, oder sie besitzen aromatische Kerne, wie N,N-Bis-(2-hydroxyethyl)-anilin oder p,p'-Bis-(2-hydroxyethylamino)-diphenylmethan, ab. Glycidylether können sich auch von einkernigen Phenolen ableiten, wie beispielsweise von Resorcin oder Hydrochinon, oder sie basieren auf mehrkernigen Phenolen, wie beispielsweise auf Bis-(4-hydroxyphenyl)-methan (Bisphenol F), 2,2-Bis-(4-hydroxyphenyl)-propan (Bisphenol A), oder auf unter sauren Bedingungen erhaltenen Kondensationsprodukten von Phenolen oder Kresolen mit Formaldehyd, wie Phenol-Novolake und Kresol-Novolake.
III) Poly-(N-glycidyl)-Verbindungen sind beispielsweise erhältlich durch Dehydrochlorierung der Reaktionsprodukte von Epichlorhydrin mit Aminen, die mindestens zwei Aminwasserstoffatome enthalten. Bei diesen Aminen handelt es sich zum Beispiel um n-Butylamin, Anilin, Toluidin, m-Xylylendiamin, Bis-(4-aminophenyl)-methan oder Bis-(4-methylaminophenyl)-methan. Zu den Poly-(N-glycidyl)-Verbindungen zählen aber auch N,N'-Diglycidylderivate von Cycloalkylenharnstoffen, wie Ethylenharnstoff oder 1,3-Propylenharnstoff, und N,N'-Diglycidylderivate von Hydantoinen, wie von 5,5-Dimethylhydantoin.
IV) Beispiele für geeignete Poly-(S-glycidyl)-Verbindungen sind Di-S-glycidylderivate, die sich von Dithiolen, wie beispielsweise Ethan-1,2-dithiol oder Bis-(4-mercaptomethylphenyl)-ether, ableiten.
V) Beispiele für Epoxidverbindungen, worin die Epoxidgruppen einen Teil eines alicyclischen oder heterocyclischen Ringsystems bilden, sind beispielsweise Bis-(2,3-epoxicyclopentyl)-ether, 2,3-Epoxicyclopentylglycidylether, 1,2-Bis-(2,3-epoxicyclopentyloxy)-ethan, Bis-(4-hydroxycyclohexyl)-methandiglycidylether, 2,2-Bis-(4-hydroxycyclohexyl)-propandiglycidylether, 3,4-Epoxycyclohexylmethyl-3,4-epoxycyclohexancarboxylat, 3,4-Epoxy-6-methyl-cyclohexylmethyl-3,4-epoxy-6-methylcyclohexancarboxylat, Di-(3,4-epoxycyclohexylmethyl)hexandioat, Di-(3,4-epoxy-6-methyl-cyclohexylmethyl)hexandioat, Ethylenbis-(3,4-epoxycyclohexancarboxylat), Ethandioldi-(3,4-epoxycyclohexylmethyl)-ether, Vinylcyclohexendioxid, Dicyclopentadiendiepoxid oder 2-(3,4-Epoxycyclohexyl-5,5-spiro-3,4-epoxy)cyclohexan-1,3-dioxan.

Es lassen sich aber auch Epoxyharze verwenden, bei denen die 1,2-Epoxidgruppen an unterschiedliche Heteroatome bzw. funktionelle Gruppen gebunden sind. Zu diesen Verbindungen zählen beispielsweise das N,N,O-Triglycidylderivat des 4-Aminophenols, der Glycidylether-glycidylester der Salicylsäure, N-Glycidyl-N'-(2-glycidyloxypropyl)-5,5-dimethylhydantoin oder 2-Glycidyloxy-1,3-bis-(5,5-dimethyl-1-glycidylhydantoin-3-yl)propan. Ferner sind auch flüssige vorreagierte Addukte solcher Epoxyharze mit Härtern für Epoxyharze geeignet.

Als Photoinitiatoren für die kationische Polymerisation können ebenfalls alle der Technik hierfür bekannten Verbindungen eingesetzt werden. Hierzu zählen beispielsweise Oniumsalze mit Anionen schwacher Nukleophilie. Beispiele dafür sind Haloniumsalze, Iodosylsalze oder Sulfon iumsalze, wie sie in der EP-A 153 904 beschrieben sind, Sulfoxoniumsalze, wie beispielsweise in den EP-A 35 969, 44 274, 54 509 und 164 314 beschrieben oder Diazoniumsalze, wie beispielsweise in der US-A 3,708,296 beschrieben. Weitere kationische Photoinitiatoren sind Metallocensalze, wie bespielsweise in den EP-A 94 914 und 94 915 beschrieben. Eine Übersicht über weitere gängige Oniumsalzinitiatoren und/oder Metallocensalze bieten "UV-Curing, Science and Technology", (Editor: S.P. Pappas, Technology Marketing Corp., 642 Westover Road, Stanford, Conneticut, USA) oder "Chemistry & Technology of UV & EB Formulation for Coatings, Inks & Paints", Vol. 3 (edited by P. K. T. Oldring).

Besonders gut geeignete Photoinitiatoren für die kationische Polymerisation sind Verbindung der Formeln (1), (2) oder (3) 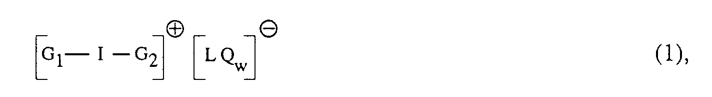 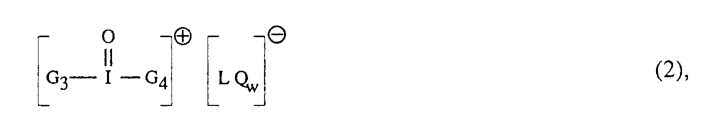 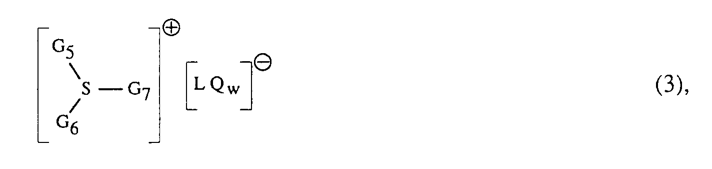 worin G₁, G₂, G₃, G₄, G₅, G₆ und G₇ unabhängig voneinander unsubstituiertes oder durch geeignete Reste substituiertes C₆-C₁₈-Aryl bedeuten, L Bor, Phosphor, Arsen oder Antimon darstellt, Q ein Halogenatom ist oder ein Teil der Reste Q in einem Anion LQ_{w}⁻ auch eine Hydroxylgruppe sein kann und w eine ganze Zahl ist, die der um 1 vergrösserten Wertigkeit von L entspricht. Beispiele für C₆-C₁₈-Aryl sind hierbei Phenyl, Naphthyl, Anthryl und Phenanthryl. Gegebenenfalls vorliegende Substituenten für geeignete Reste sind Alkyl, bevorzugt C₁-C₆-Alkyl, wie Methyl, Ethyl, n-Propyl, Isopropyl, n-Butyl, sec-Butyl, Isobutyl, tert-Butyl oder die verschiedenen Pentyl- oder Hexyl-Isomere, Alkoxy, bevorzugt C₁-C₆-Alkoxy, wie Methoxy, Ethoxy, Propoxy, Butoxy, Pentoxy oder Hexoxy, Alkylthio, bevorzugt C₁-C₆-Alkylthio, wie Methylthio, Ethylthio, Propylthio, Butylthio, Pentylthio oder Hexylthio, Halogen, wie Fluor, Chlor, Brom oder Jod, Aminogruppen, Cyanogruppen, Nitrogruppen oder Arylthio, wie Phenylthio. Beispiele für besonders vorteilhafte Halogenatome Q sind Chlor und insbesondere Fluor, Beispiele für Anionen LQ_{w}⁻ insbesondere BF₄⁻, PF₆⁻, AsF₆⁻, SbF₆⁻ und SbF₅(OH)⁻. Weiterhin kann anstatt der Anionen des Typs LQ_{w}⁻ vorteilhaft auch CF₃SO₃⁻ verwendet werden. Selbstverständlich sind auch solche Verbindungen als Initiatoren geeignet, die zwei oder mehr der Oniumgruppen im Molekül enthalten, beispielsweise Disulfoniumverbindungen. Besonders häufig werden kationische Photoinitiatoren der Formel (3) verwendet, worin G₅, G₆ und G₇ Phenyl oder Biphenyl bedeutet oder Gemische dieser beiden Verbindungen.

Ein weiterer wichtiger Typ kationischer Photoinitatoren hat die Formel (4) 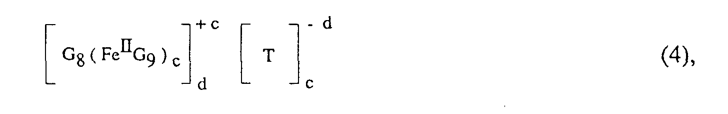 worin c 1 oder 2 bedeutet, d 1, 2, 3, 4 oder 5 ist, T für ein nicht nukleophiles Anion, z. B. BF₄⁻, PF₆⁻, AsF₆⁻, SbF₆⁻, CF₃SO₃⁻, C₂F₅SO₃⁻, n-C₃F₇SO₃⁻, n-C₄F₉SO₃⁻, n-C₆F₁₃SO₃⁻, n-C₈F₁₇SO₃⁻, C₆F₅SO₃⁻, Phosphorwolframat (PO₄₀W₁₂³⁻) oder Siliciumwolframat (SiO₄₀W₁₂⁴⁻) steht, G₈ ein π-Aren ist und G₉ ein Anion eines π-Arens, insbesondere ein Cyclopentadienylanion, bedeutet. Beispiele für hierbei geeignete π-Arene G₈ und Anionen von π-Arenen G₉ findet man in der EP-A 94 915. Wichtige π-Arene G₈ sind Toluol, Xylol, Ethylbenzol, Cumol, Methoxybenzol, Methylnaphthalin, Pyren, Perylen, Stilben, Diphenylenoxid und Diphenylensulfid. Insbesondere bevorzugt sind Cumol, Methylnaphthalin oder Stilben. Als Anion T sind PF₆⁻, ASF₆⁻, SbF₆⁻, CF₃SO₃⁻, C₂F₅SO₃⁻, n-C₃F₇SO₃⁻, n-C₄F₉SO₃⁻, n-C₆F₁₃SO₃⁻ und n-C₈F₁₇SO₃⁻ besonders geeignet. Die Ferrocensalze können ebenso wie Metallocensalze allgemein auch in Kombination mit Oxidationsmitteln eingesetzt werden. Solche Kombinationen sind in der EP-A 126 712 beschrieben.

Die kationischen Photoinitiatoren können selbstverständlich in den üblichen wirksamen Mengen zugesetzt werden, beispielsweise jeweils in Mengen von etwa 0,1 bis etwa 20, bevorzugt von 1 bis 10 Gewichtsprozent, bezogen auf die Gesamtmenge des Gemisches. Zur Erhöhung der Lichtausbeute können je nach Initiatortyp auch Sensibilisatoren eingesetzt werden. Beispiele hierfür sind polycyclische aromatische Kohlenwasserstoffe oder aromatische Ketoverbindungen. Spezifische Beispiele bevorzugter Sensibilisatoren sind in der EP-A-0 153 904 erwähnt.

Die flüssigen, strahlungshärtbaren Zusammensetzungen können auch weitere üblicherweise in der Technik photopolymerisierbarer Materialien eingesetzte Bestandteile enthalten, z. B. für die jeweiligen Komponenten geeignete inerte Lösungsmittel oder übliche Additive, wie Stabilisatoren, z. B. UV-Stabilisatoren, Trennmittel, Benetzungsmittel, Verlaufsmittel, Antiabsetzmittel, oberflächenaktive Mittel, Farbstoffe, Pigmente oder Füllstoffe. Die Additive werden jeweils in einer für den erwünschten Zweck wirksamen Menge eingesetzt und können insgesamt z. B. bis 20 Gewichtsprozent der erfindungsgemässen Zusammensetzungen ausmachen.

Bevorzugt befindet sich der lonenaustaucher bei dem genannten Stereolithographieverfahren in einem der oben schon geschilderten Behälter, die für den lonenaustauscher völlig undurchlässig, für die härtbare Zusammensetzung aber zumindest an einer Stelle durchlässig sind. Dieser Behälter wird zumindest zeitweise in das Stereolithographiebad eingebracht. Bei dem Behälter kann es sich beispielsweise um eine Patrone mit mindestens einer, bevorzugt zwei, insbesondere gegenüberliegenden, porösen Wänden handeln, wobei der Durchmesser der Poren so gering ist, dass das lonenaustauschermaterial nicht aus dem Behälter austreten kann.

Bevorzugt wird weiterhin eine Relativbewegung zwischen der flüssigen Zusammensetzung in dem Stereolithographiebad und dem Behälter erzeugt, während sich der Behälter in dem Bad befindet, so dass ein möglichst intensiver Kontakt des lonenaustauschers mit dem gesamten Badmaterial möglich ist.

Für die Stereolithographie hierbei besonders geeignete flüssige härtbare Zusammensetzungen basieren insbesondere auf flüssigen Epoxidharzen als kationisch härtbaren Verbindungen, wie z. B. den oben schon genannten Epoxidharzen. Besonders bevorzugt handelt es sich um sogenannte Hybridsysteme, d. h. um Zusammensetzungen, die neben den kationisch härtbaren Komponenten mindestens noch eine radikalisch härtbare Verbindung und einen für sie geeigneten Photoinitiator für die radikalische Polymerisation enthalten. Derartige Hybridsysteme sind z. B. in der EP-A-0 360 869 oder der EP-A-0 605 361 beschrieben, deren Beschreibung als Bestandteil dieser Beschreibung zu betrachten ist.

Die radikalisch polymerisierbaren Verbindungen können beispielsweise in Mengen von 0 bis 80 Gewichtsprozent, bezogen auf die gesamte Zusammensetzung, verwendet werden. Beispielsweise kann es sich um eine Zusammensetzung mit 5 bis 30 Gewichtsprozent radikalisch härtbarer Komponenten und 70 bis 95 Gewichtsprozent kationisch härtbarer Komponenten handeln. Häufig handelt es sich bei den radikalisch polymerisierbaren Verbindungen um Monoacrylate, Di- und Polyacrylate mit einer Acrylatfunktionalität bis zu 9 oder entsprechenden Methacrylate sowie Vinyl-Verbindungen mit einer Vinylfunktionalität bis zu 6.

Als Mono(meth-)acrylate eignen sich beispielsweise Allylacrylat, Allylmethacrylat, Methyl-, Ethyl-, n-Propyl-, n-Butyl-, Isobutyl-, n-Hexyl-, 2-Ethylhexyl-, n-Octyl-, n-Decyl- und n-Dodecylacrylat und -methacrylat, 2-Hydroxyethyl-, 2- und 3-Hydroxypropylacrylat und -methacrylat, 2-Methoxyethyl-, 2-Ethoxyethyl- und 2- oder 3-Ethoxypropylacrylat, Tetrahydrofurfurylmethacrylat, 2-(2-Ethoxyethoxy)ethylacrylat, Cyclohexylmethacrylat, 2-Phenoxyethylacrylat, Glycidylacrylat und Isodecylacrylat, sowie als Mono-N-vinylverbindung N-Vinylpyrrolidon oder N-Vinylcaprolactam. Solche Produkte sind ebenfalls bekannt und zum Teil im Handel erhältlich, zum Beispiel von der Firma SARTOMER Company.

Als zusätzliche Di(meth-)acrylate eignen sich beispielsweise die Di(meth-)acrylate von cycloaliphatischen oder aromatischen Diolen, wie 1,4-Dihydroxymethylcyclohexan, 2,2-Bis-(4-hydroxycyclohexyl)-propan, Bis-(4-hydroxycyclohexyl)-methan, Hydrochinon, 4,4'-Dihydroxybiphenyl, Bisphenol A, Bisphenol F, Bisphenol S, ethoxyliertes oder propoxyliertes Bisphenol A, ethoxyliertes oder propoxyliertes Bisphenol F oder ethoxyliertes oder propoxyliertes Bisphenol S. Solche Di(meth-)acrylate sind bekannt und zum Teil im Handel erhältlich.

Als Di(meth-)acrylate können auch Verbindungen der Formeln (5), (6) (7) oder (8) 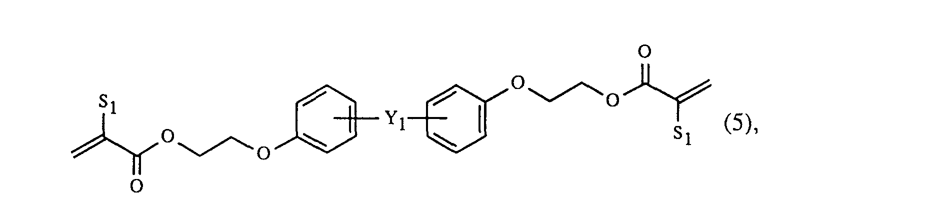 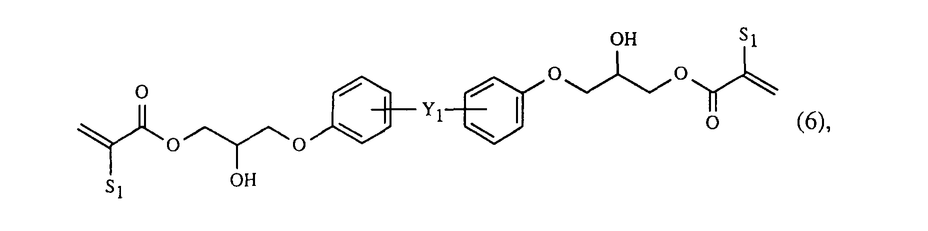 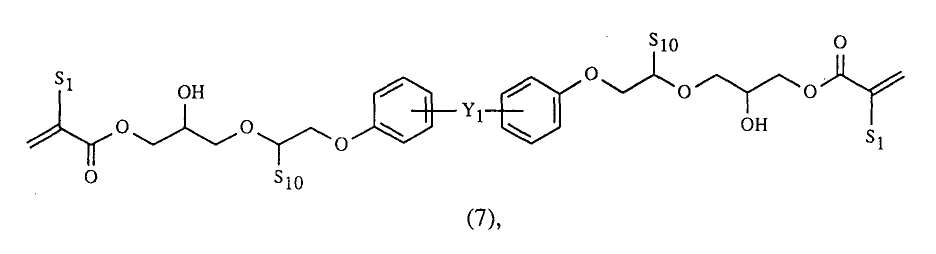 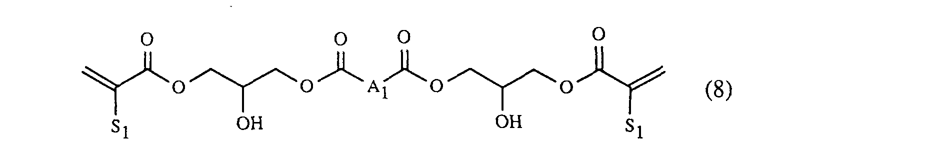 eingesetzt werden, worin S₁ ein Wasserstoffatom oder Methyl bedeutet, Y₁ für eine direkte Bindung, C₁-C₆-Alkylen, -S-, -O-, -SO-, -SO₂- oder -CO- steht, S₁₀ für eine C₁-C₈-Alkylgruppe, eine unsubstituierte oder durch eine oder mehrere C₁-C₄-Alkylgruppen, Hydroxygruppen oder Halogenatome substituierte Phenylgruppe, oder für einen Rest der Formel -CH₂-OS₁₁ steht, worin S₁₁ eine C₁-C₈-Alkylgruppe oder Phenylgruppe bedeutet und A₁ einen Rest aus gewählt aus den Resten der Formeln 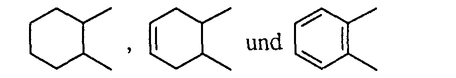 darstellt.

Die Di(meth-)acrylate der Formeln (5) und (6) sind bekannt und zum Teil im Handel erhältlich, beispielsweise unter der Bezeichung SR® 349 oder Novacure® 3700, und können hergestellt werden, indem man ethoxylierte Bisphenole, insbesondere ethoxyliertes Bisphenol A, oder Bisphenoldiglycidylether, insbesondere Bisphenol A-diglycidylether, mit (Meth)acrylsäure zu den Verbindungen der Formeln (5) oder (6) umsetzt.

In gleicher Weise können auch die Verbindungen der Formeln (7) und (8) hergestellt werden, indem man einen Diglycidylether der Formel (7a) 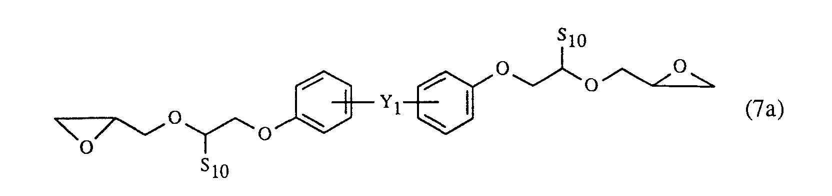 oder einen Diglycidylester der Formel (8a) 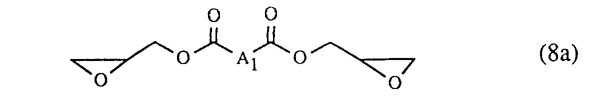 mit (Meth)acrylsäure zu den Verbindungen der Formel (7) oder (8) umsetzt, wobei S₁₀, Y₁ und A₁ die oben angegebene Bedeutung haben.

Ferner können als Diacrylate auch eine Verbindung der Formeln (9), (10), (11) oder (12) 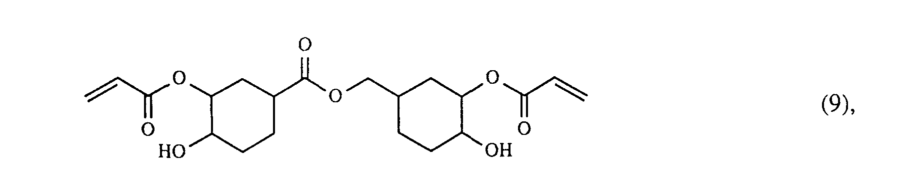 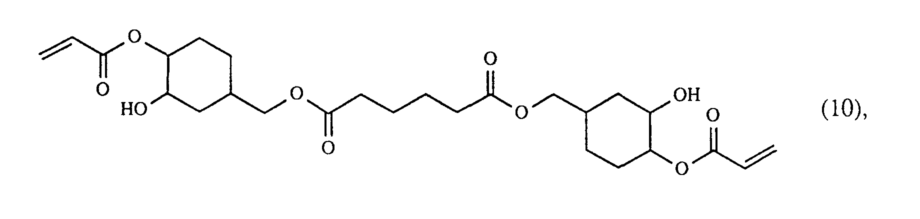 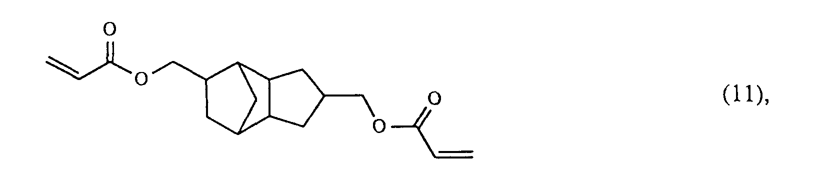 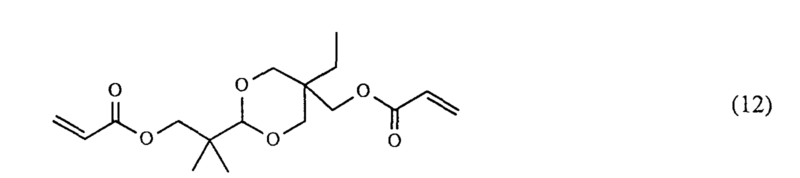 verwendet werden. Diese Verbindungen sind bekannt und zum Teil im Handel erhältlich. Beispielsweise können die Verbindungen der Formeln (9) und (10) in bekannter Weise durch Umsetzen der cycloaliphatischen Diepoxide der Formeln (9a) beziehungsweise (10a) 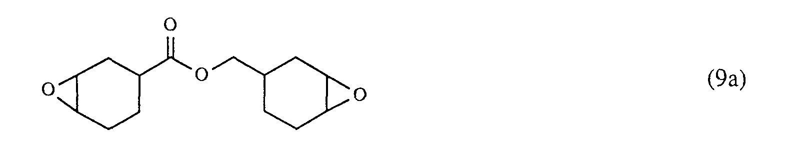 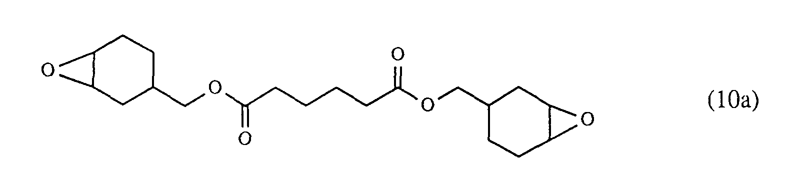 mit (Meth)acrylsäure zu den Verbindungen der Formeln (9) oder (10) erhalten werden. Die Verbindung der Formel (12) ist im Handel unter der Bezeichung Kayarad® R-604 erhältlich.

Als zusätzliche Poly(meth-)acrylate kommen z. B. monomere oder oligomere aliphatische, cycloaliphatische oder aromatische Acrylate oder Methacrylate mit einer (Meth-)Acrylatfunktionalität von grösser als 2, insbesondere tri-, tetra- oder pentafunktionelle Acrylate oder Methacrylate, in Frage.

Als aliphatische polyfunktionelle (Meth-)Acrylate eignen sich beispielsweise die Triacrylate und Trimethacrylate von Hexan-2,4,6-triol, Glycerin oder 1,1,1-Trimethylolpropan, ethoxyliertes oder propoxyliertes Glycerin oder 1,1,1-Trimethylolpropan und die hydroxygruppenhaltigen Tri(meth-)acrylate, die durch Umsetzung von Triepoxidverbindungen, wie beispielsweise die Triglycidylether von den genannten Triolen, mit (Meth-)Acrylsäure erhalten werden. Weiterhin können zum Beispiel Pentaerythritoltetraacrylat, Bistrimethylolpropantetraacrylat, Pentaerythritolmonohydroxytriacrylat oder -methacrylat oder Dipentaerythritolmonohydroxypentaacrylat oder -methacrylat verwendet werden.

Ausserdem können als weitere radikalisch polymerisierbare Verbindungen in den erfindungsgemässen Zusammensetzungen hexafunktionelle oder höherfunktionelle Urethanacrylate oder Urethanmethacrylate verwendet werden. Diese Urethan(meth-)acrylate sind dem Fachmann bekannt und können in bekannter Weise hergestellt werden, indem man beispielsweise ein hydroxylterminiertes Polyurethan mit Acrylsäure oder Methacrylsäure umsetzt, oder indem man ein isocyanatterminiertes Präpolymer mit Hydroxyalkyl(meth)acrylaten zum Urethan(meth-)acrylat umsetzt.

Als aromatische Tri(meth-)acrylate eignen sich beispielsweise die Umsetzungsprodukte aus Triglycidylethern dreiwertiger Phenole und drei Hydroxylgruppen aufweisende Phenol- oder Kresolnovolake mit (Meth)-Acrylsäure.

Vorzugsweise enthalten die erfindungsgemässen Zusammensetzungen mindestens ein in der Zusammensetzung lösliches (Meth)acrylat mit einer Acrylatfunktionalität von 1 bis 9, besonders bevorzugt enthalten sie eine flüssige Mischung aus aromatischen, aliphatischen oder cycloaliphatischen (Meth)acrylaten mit einer Acrylatfunktionalität von 2 bis 9.

Als Photoinitiatoren für die radikalische Polymersation können wiederum alle Verbindungstypen in Frage, welche bei der entsprechenden Bestrahlung freie Radikale bilden. Typische Verbindungen bekannter Photoinitiatoren sind Benzoine, wie Benzoin, Benzoinether, wie Benzoinmethylether, Benzoinethylether und Benzoinisopropylether, Benzoinphenylether und Benzoinacetat, Acetophenone, wie Acetophenon, 2,2-Dimethoxyacetophenon und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert-Butylanthrachinon, 1-Chloranthrachinon und 2-Amylanthrachinon, ferner Triphenylphosphin, Benzoylphosphinoxide, wie beispielsweise 2,4,6-Trimethylbenzoyldiphenylphosphinoxid (Luzirin TPO), Benzophenone, wie Benzophenon und 4,4'-Bis-(N,N'-dimethylamino)-benzophenon, Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton, welche alle bekannte Verbindungen darstellen.

Besonders geeignete Photoinitiatoren, welche gewöhnlich in Kombination mit einem He/Cd-Laser als Lichtquelle verwendet werden, sind Acetophenone, wie 2,2-Dialkoxybenzophenone und 1-Hydroxyphenylketone, beispielsweise 1-Hydroxycyclohexylphenylketon oder 2-Hydroxyisopropylphenylketon (= 2-Hydroxy-2,2-dimethylacetophenon), insbesondere aber 1-Hydroxycyclohexylphenylketon.

Eine andere Klasse von radikalischen Photoinitiatoren, die gewöhnlich bei Verwendung von Argonionen-Lasern eingesetzt wird, sind die Benzilketale, wie beispielsweise Benzildimethylketal. Insbesondere verwendet man als Photoinitiator ein α-Hydroxyphenylketon, Benzildimethylketal oder 2,4,6-Trimethylbenzoyldiphenylphosphinoxid.

Eine weitere Klasse von geeigneten radikalischen Photoinitiatoren stellen die ionischen Farbstoff-Gegenionverbindungen (ionic dye-counter ion compounds) dar, welche in der Lage sind, aktinische Strahlen zu absorbieren und freie Radikale zu erzeugen, die die Polymerisation von Substanzen, wie (Meth)acrylaten oder Vinylverbindungen initiieren. Die erfindungsgemässen Gemische, welche ionische Farbstoff-Gegenionverbindungen enthalten, können auf diese Weise mit sichtbarem Licht im einstellbaren Wellenlängenbereich von 400-700 nm variabler gehärtet werden. Ionische Farbstoff-Gegenionverbindungen und deren Wirkungsweise sind bekannt, beispielsweise aus der EP-A-0 223 587 und den US-Patenten 4,751,102; 4,772,530 und 4,772,541. Als Beispiele für geeignete ionische Farbstoff-Gegenionverbindungen seien genannt die anionischen FarbstoffJodoniumionkomplexe, die anionischen Farbstoff-Pyrylliumionkomplexe und insbesondere die kationischen Farbstoff-Boratanionverbindungen der Formel 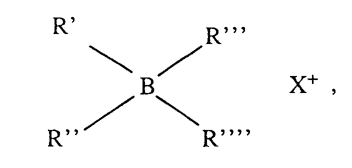 worin X⁺ für einen kationischen Farbstoff steht und R', R", R"' und R"" unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten.

Es ist dem Fachmann bekannt, dass für jede gewählte Lichtquelle geeignete Photoinitiatoren ausgewählt oder gegebenenfalls hierfür sensibilisiert werden müssen. Man hat erkannt, dass die Eindringtiefe der Strahlen in die zu polymerisierende Zusammensetzung und die Arbeitsgeschwindigkeit in direktem Zusammenhang mit dem Absorptionskoeffizienten und der Konzentration des Photoinitiators stehen. In der Stereolithographie werden vorzugsweise solche Photoinitiatoren eingesetzt, welche für eine bestimmte Laserenergie die höchste Anzahl von entstehenden freien Radikalen beziehungsweise kationischen Partikeln bewirken, so dass bei der eingestellten Härtungstiefe ein Grünling von optimaler Festigkeit entsteht. Sowohl kationische wie auch radikalische Photoinitiatoren werden den Stereolithographiegemischen in wirksamen Mengen zugesetzt, insbesondere jeweils in Mengen von etwa 0,1 bis etwa 10 Gewichtsprozent, bezogen auf die Gesamtmenge des Gemisches, wobei es, insbesondere bei Einsatz von Lasern zur Strahlungshärtung, wesentlich ist, dass die Absorptionsfähigkeit der Gemische durch Typ und Konzentration des Photoinitiators so abgestimmt wird, dass die Härtungstiefe bei normaler Lasergeschwindigkeit ungefähr 0,1 bis 2,5 mm beträgt. Bevorzugt liegt die Gesamtmenge an Photoinitiatoren in den erfindungsgemässen Zusammensetzungen zwischen 0,5 und 5 Gewichtsprozent.

Selbstverständlich können auch die Stereolithographiebäder für die vorliegende Erfindung die üblichen in dieser Technik gebräuchlichen Zusatzstoffe enthalten, beispielsweise die oben schon genannten Additive oder zusätzliche Vernetzungsmittel, wie Di- oder Polyole.

Abgesehen von der erfindungsgemässen Stabilisierung kann das Stereolithographieverfahren selbstverständlich in jeder üblichen Weise durchgeführt werden, beispielsweise wie in US-A-4,575,330 oder in EP-A-0 605 361 beschrieben.

### Beispiel 1:

200 g eines nassen schwach basischen Ionenaustauschers (Amberlyst® A21 der Firma Rohm & Haas) werden dreimal mit jeweils 300 Millilitern wasserfreiem Ethanol sowie dreimal mit je 300 Millilitern Ethylacetat gewaschen, wobei die Austauschermasse nach jedem Waschvorgang trockengesaugt wurde. Das so gewaschene Ionenaustauscherharz wird schliesslich über Nacht bei 60 °C bei einem Druck von 0,1 hPa getrocknet.

100g Cibatool™SL 5180, eine kommerziell erhältliche Zusammensetzung für die Stereolithographie auf Basis von Epoxidharzen als kationisch polymerisierbaren Verbindungen und einem Sulfoniumsalz der Formel 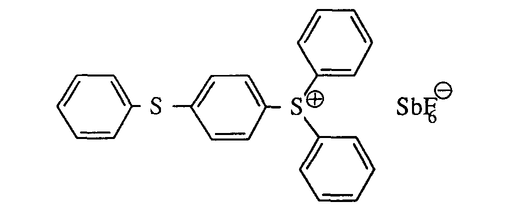 als Photoinitiator für die kationische Polymerisation sowie weiteren radikalisch polymerisierbaren Bestandteilen (Hybridsystem) werden mit 1 g des oben genannten Ionenaustauschers in eine braungefärbte Glasflasche gegeben und 24 Stunden lang in einem 80 °C heissen Konvektionsofen einem beschleunigten Alterungstest unterzogen. Die Viskosität der Zusammensetzung (bestimmt bei 30 °C mit einem Brookfield Viskosimeter mit Spindel #21) beträgt 180 mPa·s, genauso wie vor der Heisslagerung. Gibt man hingegen keinen Ionenaustauscher zu der Zusammensetzung beträgt die Viskosität des Harzes nach 24-stündiger Lagerung im 80 °C heissen Ofen 190 mPa·s (ebenfalls bestimmt bei 30 °C mit einem Brookfield Viskosimeter mit Spindel 21).

Die Photoempfindlichkeit wird nach der sogenannten "Window-pane Technik", beschrieben in Dr. Paul F. Jakobs "RAPID PROTOTYPING & MANUFACTURING, FUNDAMENTALS OF STEREOLITHOGRAPHY", herausgegeben von SME, Dearborn, Michigan U. S. A., Seite 263 - 277, mit Hilfe eines Ar/UV-Lasers bestimmt, wobei 351 nm Strahlung von 20 mW verwendet wird. Für die Zusammensetzung mit Ionenaustauscher findet man nach der 24-stündigen Lagerung bei 80 °C eine Strahlungseindringtiefe Dp von ca. 0,17 mm und eine kritische Energie Ec von 22,3 mJ/cm³, also vergleichbar den Werten für die frische Lösung (Strahlungseindringtiefe ca. 0,17 mm und kritische Energie 21,3 mJ/cm³).

### Beispiel 2:

Aus einem Bad mit insgesamt 100 g Cibatool™SL 5180 werden mittels Stereolithographie 10 Grünlinge im Quicklast™ Baustil gemäss "RAPID PROTOTYPING SYSTEMS FAST TRACK TO PRODUCT REALIZATION SME, Dearborn, Mi 48121, 1994, Seite 68ff, mit den Abmessungen 80x4x4 mm hergestellt. Die Streifen werden 7 Tage in dem Bad belassen (Testprobe 1). Testprobe 2 ist frisch hergestelltes Cibatool™SL 5180 und Testprobe 3 frisch hergestelltes Cibatool™SL 5180, das 1 Gewichtsprozent des schwach basischen Ionenaustauschers Amberlyst® A21 (nicht gewaschen) enthält. Die Proben werden 21 Tage bei 80 °C im Ofen gelagert, wobei im Abstand von einigen Tagen jeweils die Viskosität bei 30 °C mit einem Brookfield Viskosimeter mit Spindel #21 bestimmt wird. Man findet die in der folgenden Tabelle genannten Viskositäten.

| Viskosität [mPa·s] | | | |
|---|---|---|---|
| nach Lagerung von: | Probe 1 | Probe 2 | Probe 3 |
| 0 Tagen | 156 | 156 | 156 |
| 5 Tagen | - | - | 249 |
| 6 Tagen | 10700 | 818 | - |
| 9 Tagen | geliert | 1510 | 364 |
| 12 Tagen | | 3420 | 411 |
| 14 Tagen | | 6180 | - |
| 16 Tagen | | 12100 | 503 |
| 21 Tagen | | geliert | - |
| 24 Tagen | | | 618 |

Das Beispiel macht deutlich, dass Probe 1 schon nach 9 Tagen geliert ist. Es wird angenommen, dass aus dem Grünling Säure in das Bad diffundiert und dieses Ausdiffundieren von Protonen aus den Grünlingen ausschlaggebend für den starken Anstieg der Viskosität in herkömmlichen nicht stabilisierten Stereolithographiebädern ist. Auch die frische Zusammensetzung (Probe 2) zeigt während der Lagerung einen schnellen Viskositätsanstieg, während die erfindungsgemäss stabilisierte Probe 3 nur einen minimalen Anstieg der Viskosität erkennen lässt.

### Beispiel 3:

100 g Cibatool™ SL 5180 werden mit 0,1 g des gewaschenen Ionenaustauschers gemäss Beispiel 1 in eine braun gefärbte Glasflasche gegeben und 26 Tage in einem 80 °C heissen Konvektionsofen einem beschleunigten Alterungstest unterzogen. Die Viskosität der Testprobe (bestimmt bei 30 °C mit einem Brookfield Viskosimeter mit Spindel #21) wird im Abstand von einigen Tagen gemessen. Die Photoempfindlichkeit wird zur gleichen Zeit nach der "Window-pane" Methode (Bedingungen wie in Beispiel 1) mit Hilfe eines Ar/UV-Lasers bestimmt. Man erhält die folgenden Werte:

| Lagerdauer | Viskosität [mPa·s] | Strahlungseindringtiefe [mm] | kritische Energie [mJ/cm²] |
|---|---|---|---|
| 0 Tage | 156 | 0,18 | 23,9 |
| 11 Tage | 214 | 0,19 | 27,5 |
| 26 Tage | 260 | 0,18 | 28 |

### Beispiel 4:

69,2 g 3,4-Epoxycyclohexylmethyl-3,4-epoxycyclohexancarboxylat, 27,2 g Tone® 0301 (Additionsprodukt von 1 Mol Trimethylolpropan und 3 Mol Caprolacton), 0,5 g eines Photoinitiators der Formel 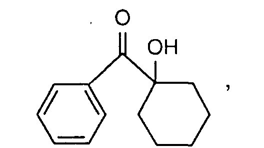 3 g eines Photoinitiators der Formel 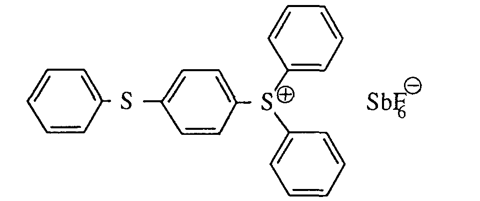 und 0,1 g Pyren werden in einer braun gefärbten Glasflasche gemischt und für 20 Tage in einem 80 °C heissen Ofen einem beschleunigten Alterungstest unterzogen (Testprobe 1). 100 g derselben Mischung werden mit 0,1 g gewaschenem Ionenaustauscher des Typs Amberlyst® A 21 versetzt und demselben Test unterzogen (Testprobe 2). Die Viskositäten der Testproben (bei 30 °C mit Brookfieldviskosimeter, Spindel #21) werden im Abstand von einigen Tagen bestimmt und die folgenden Werte gemessen:

| Lagerdauer | Testprobe 1 Viskosität [mPa·s] | Testprobe 2 Viskosität [mPa·s] |
|---|---|---|
| 0 Tage | 336 | 336 |
| 10 Tage | 1290 | 459 |
| 13 Tage | 2020 | 508 |
| 20 Tage | 5460 | 660 |

## Patentansprüche

1. Verfahren zur stereolithographischen Herstellung dreidimensionaler Körper mit Hilfe einer flüssigen strahlungshärtbaren Zusammensetzung, enthaltend eine kationisch polymerisierbare Verbindung und einen Photoinitiator für die kationische Polymerisation, bei dem ein basischer lonenaustauscher mit der Zusammensetzung zumindest zeitweise in Kontakt gebracht wird, so dass er die Zusammensetzung gegen einen vorzeitigen Beginn der Polymerisation stabilisiert.

2. Verfahren nach Anspruch 1, bei dem lösliche basische Verunreinigungen aus dem lonenaustauschermaterial entfernt werden, bevor der lonenaustauscher mit der flüssigen strahlungshärtbaren Zusammensetzung in Kontakt gebracht wird.

3. Verfahren nach einem der Ansprüche 1 oder 2, bei dem als lonenaustauscher ein vernetztes Copolymer von Styrol, Divinylbenzol und Dimethylaminomethylstyrol eingesetzt wird.

4. Verfahren nach einem der Ansprüche 1 bis 3, bei dem der lonenaustauscher vor Beginn der Strahlungshärtung zumindest aus dem Teil der strahlungsempfindlichen Zusammensetzung entfernt wird, der mit der Strahlung in Kontakt kommt.

5. Verfahren nach einem der Ansprüche 1 bis 4, bei dem der basische lonenaustauscher der strahlungshärtbaren Zusammensetzung am Ende des Herstellungsprozesses zugegeben wird.

6. Verfahren nach einem der Ansprüche 1 bis 3, bei dem sich der lonenaustaucher in einem Behälter befindet, der zumindest zeitweise in das Stereolithographiebad eingebracht wird und der für den lonenaustauscher völlig undurchlässig, für die härtbare Zusammensetzung aber zumindest an einer Stelle durchlässig ist.

7. Verfahren nach Anspruch 6, bei dem eine Relativbewegung zwischen der flüssigen Zusammensetzung in dem Stereolithographiebad und dem Behälter stattfindet, während sich der Behälter in dem Bad befindet.

8. Verfahren nach einem der Ansprüche 1 bis 7, bei dem die flüssige strahlungshärtbare Zusammensetzung mindestens ein Epoxidharz als kationisch polymerisierbare Verbindung enthält.

9. Verfahren nach Anspruch 8, bei dem die flüssige strahlungshärtbare Zusammensetzung mindestens noch eine radikalisch härtbare Verbindung oder ein Gemisch von zwei oder mehreren dieser Verbindungen und einen Photoinitiator für die radikalische Polymerisation enthält.

## Claims

1. A process for stereolithographically producing three-dimensional structures using a liquid radiation-curable composition comprising a cationically polymerizable compound and a photoinitator for cationic polymerization, in which a basic ion exchanger is brought into contact with the composition, at least for a certain time, so that it protects the composition against premature commencement of polymerization.

2. A process according to claim 1, in which soluble basic impurities are removed from the ion exchanger material before the ion exchanger is brought into contact with the liquid radiation-curable composition.

3. A process according to one of claims 1 and 2, in which the ion exchanger used is a crosslinked copolymer of styrene, divinylbenzene and dimethylaminomethylstyrene.

4. A process according to one of claims 1 to 3, in which the ion exchanger is removed before commencement of the radiation curing, at least from the part of the radiation-sensitive composition which comes into contact with the radiation.

5. A process according to one of claims 1 to 4, in which the basic ion exchanger is added to the radiation-curable composition at the end of the preparation process.

6. A process according to one of claims 1 to 3, in which the ion exchanger is in a container which is introduced into the stereolithography bath, at least for a certain time, and which is totally impermeable to the ion exchanger but is permeable to the curable composition, at least in one area.

7. A process according to claim 6, in which a relative movement takes place between the liquid composition in the stereolithography bath and the container while the container is in the bath.

8. A process according to one of claims 1 to 7, in which the cationically polymerizable compound in the liquid radiation-curable composition is at least one epoxy resin.

9. A process according to claim 8, in which the liquid radiation-curable composition also comprises at least a compound which can be cured by means of free radicals or a mixture of two or more of these compounds, and a photoinitiator for free-radical polymerization.

## Revendications

1. Procédé pour la préparation stéréo-lithographique de corps tridimensionnels à l'aide d'une composition liquide durcissable par irradiation, contenant un composé polymérisable par polymérisation cationique et un photoamorceur pour la polymérisation cationique, où on met en contact, au moins temporaire, un échangeur d'ions basique et la composition de sorte qu'il stabilise la composition contre un début de polymérisation prématurée.

2. Procédé selon la revendication 1, où on élimine des impuretés basiques solubles de la matière échangeuse d'ions avant la mise en contact de l'échangeur d'ions avec la composition liquide durcissable par irradiation.

3. Procédé selon l'une des revendications 1 ou 2, où on utilise comme échangeur d'ions un copolymère réticulé de styrène, de divinylbenzène et de diméthylaminostyrène.

4. Procédé selon l'une des revendications 1 à 3, où on élimine l'échangeur d'ions avant le durcissement par irradiation au moins à partir de la partie de la composition sensible au rayonnement qui entre en contact avec le rayonnement.

5. Procédé selon l'une des revendications 1 à 4, où on ajoute l'échangeur d'ions basique à la composition durcissable par irradiation à la fin du procédé de préparation.

6. Procédé selon l'une des revendications 1 à 3, où l'échangeur d'ions se trouve dans un récipient qui est placé au moins temporairement dans le bain de stéréolithographie et ledit récipient étant entièrement imperméable pour l'échangeur d'ions, mais qui est perméable, à un endroit au moins, pour la composition durcissable.

7. Procédé selon la revendication 6, où un mouvement relatif est créé entre la composition liquide dans le bain de stéréolithographie et le récipient, pendant que le récipient se trouve dans le bain.

8. Procédé selon l'une des revendications 1 à 7, où la composition liquide durcissable par irradiation contient au moins une résine époxyde en tant que composé polymérisable par polymérisation cationique.

9. Procédé selon la revendication 8, où la composition liquide durcissable par irradiation contient encore au moins un composé durcissable par voie radicalaire ou un mélange de deux ou plusieurs de ces composés et un photoamorceur pour la polymérisation radicalaire.
